Europäisches Patentamt

European Patent Office

Office européen des brevets

(19)

(11) Numéro de publication : **0 038 755**
**B1**

(12) **FASCICULE DE BREVET EUROPÉEN**

(45) Date de publication du fascicule du brevet :
15.08.84

(51) Int. Cl.³ : **G 11 C 19/08**

(21) Numéro de dépôt : **81400617.7**

(22) Date de dépôt : **17.04.81**

(54) **Mémoire à bulles magnétiques.**

(30) Priorité : **18.04.80 FR 8008764**

(43) Date de publication de la demande :
**28.10.81 Bulletin 81/43**

(45) Mention de la délivrance du brevet :
**15.08.84 Bulletin 84/33**

(84) Etats contractants désignés :
**DE GB IT NL**

(56) Documents cités :
**WO-A-79 /003 60**
**IEEE TRANSACTIONS ON MAGNETICS, vol. 13, no. 6, novembre 1977 New York US Y.S. LIN et al.: "Contiguous-Disk Bubble Domain Devices", pages 1744-1764**
**JOURNAL OF APPLIED PHYSICS, vol. 50, no. 3, mars 1979, New York, US W.P. LEE et al.: "Wafer integrated bubble memory chip", pages 2283-2285**

(73) Titulaire : **COMMISSARIAT A L'ENERGIE ATOMIQUE Etablissement de Caractère Scientifique Technique et Industriel**
**B.P. 510**
**F-75752 Paris Cedex 15 (FR)**

(72) Inventeur : **Boshra-Riad, Mokhtar**
**12, Rue Aly Elshiemy**
**Alharam Giza (EG)**
Inventeur : **Fedeli, Jean-Marc**
**Beauséjour Le Fontanil Cornillon**
**F-38120 Saint Egreve (FR)**
Inventeur : **Jouve, Hubert**
**8, Domaine des Plantées**
**F-38330 Biviers (FR)**
Inventeur : **Mauduit, Daniel**
**Charnècles**
**F-38140 Rives Sur Fure (FR)**

(74) Mandataire : **Mongrédien, André et al**
**c/o BREVATOME 25, rue de Ponthieu**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

## Description

La présente invention concerne une mémoire à bulles magnétiques. Elle s'applique au transfert d'informations binaires ou bits, matérialisées sous la forme de domaines isolés qualifiés de « bulles », à l'intérieur de la mémoire, ou vers une station d'accès à ces informations.

Les bulles magnétiques sont matérialisées sous la forme de domaines isolés qui présentent une aimantation inverse de celle du reste du matériau magnétique qui constitue la couche dans laquelle les bulles sont formées. Chaque bulle peut être déplacée par une force et le mouvement peut s'effectuer librement dans n'importe quelle direction, dans le plan de la couche magnétique. La couche magnétique est un grenat magnétique et les bulles sont formées dans cette couche en lui appliquant un champ magnétique continu perpendiculaire au plan de la couche. Ce champ est produit dans la pratique, par un aimant permanent ; il assure la non-volatilité des informations contenues dans la mémoire.

La couche de grenat magnétique dans laquelle sont formées les bulles, est généralement supportée par un grenat monocristallin amagnétique.

Il est connu de déplacer les bulles grâce à l'application d'un champ magnétique tournant dont le rôle est de créer des pôles sur des motifs en permalloy par exemple, qui présentent la forme de barres en T, en chevrons, ou la forme de demi-disques. On réalise ainsi des registres à décalage dans lesquels l'information binaire est représentée par la présence « 1 » ou l'absence « 0 » d'une bulle. En plus de ces motifs en permalloy, on sait qu'il est nécessaire d'utiliser des conducteurs électriques pour réaliser sur la puce de mémoire à bulles, des fonctions d'écriture, d'enregistrement de l'information, de lecture non desctructive, de transfert de registre à registre et d'effacement. L'effacement est réalisé bit par bit, par destruction sélective des bulles ou, globalement. Cet effacement est obtenu très simplement en augmentant la valeur du champ magnétique continu, au delà de la valeur maximum permise pour l'enregistrement.

Pour déplacer les bulles dans la couche de grenat magnétique, on sait actuellement utiliser deux techniques : les bulles peuvent être déplacées soit par courant électrique, soit par champ magnétique.

Les principaux types de mémoire à bulles magnétiques, connus, sont les suivants :

— les mémoires constituées par un registre bouclé simple, qui peuvent être qualifiées de mémoires à organisation série, dans lesquelles apparaît un seul registre à décalage, bouclé et très long. Ce registre est muni d'une seule station d'accès capable d'accéder à un seul bit à la fois. Ce type de mémoire, bien que très simple nécessite un temps d'accès très long, ne permettant aucun accès aléatoire ; il nécessite une fabrication parfaite. En effet, tout défaut pourrait produire une coupure dans la chaîne de bulles qui représente les informations contenues dans le registre ;

— les mémoires présentant une organisation en « registres mineurs-registre majeur ». Ces mémoires comprennent un ensemble de boucles d'enregistrement très courtes, appelées « registres mineurs », qui permettent d'enregistrer les informations. Une autre boucle appelée « registre majeur », comporte la station d'accès. Les registres mineurs sont disposés longitudinalement, les uns à côté des autres et le registre majeur est orienté transversalement ; les bulles magnétiques contenues dans les registres mineurs peuvent être transférées dans le registre majeur par l'intermédiaire de portes de transfert. Ces portes compliquent la structure et la fabrication de la mémoire ; de plus, le temps d'accès est important puisque les bulles magnétiques peuvent parcourir toute la longueur du registre majeur avant de parvenir à la station d'accès, puis, suivre un chemin équivalent pour leur retour dans les registres mineurs. Enfin, le décalage dans les registres mineurs est unidirectionnel, par suite de contraintes de synchronisation dans la propagation des bulles entre les registres mineurs et le registre majeur ;

— les mémoires à bulles qui comprennent une série de registres à décalage ou registres mineurs, orientés longitudinalement, et un contour d'accès ou registre majeur disposé transversalement. Dans ce type de mémoire, le contour d'accès est incorporé aux registres mineurs qui participent ainsi par au moins deux éléments binaires ou bits au contour d'accès. Dans ce cas, l'influence du contour d'accès peut être néfaste pour des bulles voisines. En effet, en créant des gradients de champ magnétique nécessaire au déplacement des bulles sur ce contour d'accès, il est possible qu'apparaisse un affaiblissement des bulles proches dans la zone de mémoire considérée.

Par l'article de LIN et al. publié dans « IEEE Transactions on Magnetics » vol. Mag. 13, n° 6 novembre 1977 (figure 14c), on connaît aussi des mémoires à bulles magnétiques formées par des motifs définis par implantation ionique, lesdits motifs définissant de part et d'autre d'une zone frontière des répartitions complémentaires de zones implantées et de zones non implantées. Dans cet article, il est montré qu'une bulle se trouvant d'un côté de la ligne frontière, c'est-à-dire accrochée à un motif implanté se meut en phase, pour une rotation donnée du champ tournant, par rapport à une bulle se trouvant de l'autre côté de la ligne frontière, c'est-à-dire accrochée au motif complémentaire.

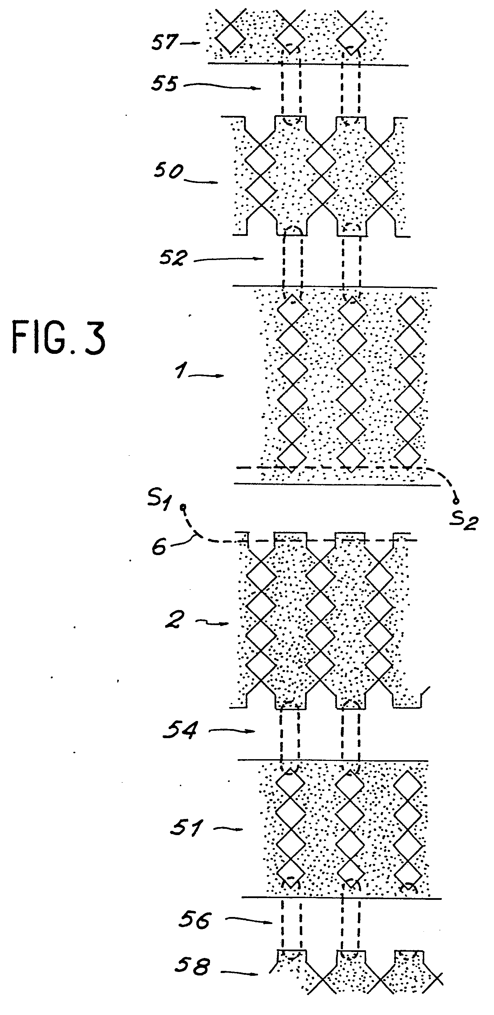

Par l'article de W.P. LEE et al. publié dans « Journal of Applied physics », mars 1979 (figure 3), il est connu d'intercaler entre des séries de registres à décalage orientés longitudinalement (registres mineurs) des registres tampons ou registres secondaires eux aussi orientés longitudinalement. Le transfert entre registres mineurs et registres tampons se fait à l'aide de registres majeurs ou contours d'accès, disposés transversalement entre registres tampons et registres mineurs, lesdits registres majeurs étant associés à des moyens permettant le transfert des bulles des registres mineurs ou tampons au registre majeur correspondant. Il est aussi connu par le document PCT WO/7900360, de réaliser des registres à décalages à bulles magnétiques en superposant à la couche magnétique contenant les bulles une feuille conductrice percée d'ouvertures, lesdites ouvertures coopérant avec des motifs réalisés par implantation dans la couche magnétique.

Pour les mémoires, qui utilisent généralement des registres mineurs constitués par des motifs en permalloy présentant la forme de T, de chevrons, ou de demi-disques, il est pratiquement impossible d'assurer un transfert des bulles d'un registre mineur vers un autre registre mineur. Avec les motifs en demi-disques, la répartition des potentiels magnétiques le long du registre majeur n'est pas homogène et, lors du transfert des bulles le long de ce registre majeur, des discontinuités de champ apparaissent et peuvent provoquer des affaiblissements des bulles.

L'invention a pour but de remédier à ces inconvénients et notamment de réaliser une mémoire à bulles danslaquelle les informations contenues dans les registres mineurs, à décalage orienté longitudinalement peuvent être transmises, bit par bit, à un contour d'accès orienté transversalement, grâce à la présence d'un seul point de tangence entre l'extrémité de chaque registre à décalage et le contour d'accès. De plus, cette mémoire à bulles permet de faciliter et d'accélérer les transferts, non seulement entre les registres à décalages et le contour d'accès, mais également entre des registres à décalage appartenant à différentes séries de registres situés en regard, dans la mémoire. Elle permet également d'assurer l'accès à deux adresses consécutives d'un même registre à décalage, par un seul décalage dans ce registre. Elle évite d'avoir à utiliser des portes d'accès dont la résistance élevée produit une dissipation importante, dans les mémoires connues. L'invention permet également de fabriquer ces mémoires selon une technologie plane, sans utilisation de motifs en demi-lunes, en T ou en chevrons, sans utilisation de motifs protubérants puisqu'il n'est plus nécessaire de prévoir des portes entre les registres à décalage et le contour d'accès. Elle évite aussi d'avoir à tenir compte des décalages de phase entre les impulsions qui permettent le transfert des bulles dans le contour d'accès et le champ tournant qui permet le décalage de ces bulles dans chacun des registres à décalage. Enfin, la mémoire selon l'invention, grâce au contour d'accès qui présente de simples points de tangence avec les divers registres à décalage, permet de disposer deux stations d'accès à chacune des extrémités de ce contour d'accès et ainsi de diminuer le temps d'accès aux informations contenues dans les registres à décalage. Les transferts de registre à registre à l'intérieur d'une même série de registres à décalage ou dans deux séries adjacents, sont également accélérés. Les registres de deux séries de registres de part et d'autre du contour d'accès sont complémentaires et, pour une même position du champ tournant, les puits de potentiel pour ces deux séries, sont face à face et les bulles qui y seraient piégées, peuvent être prises en compte par le contour d'accès, sans faire appel à une rotation supplémentaire du champ tournant. Dans ces conditions, comme on le verra plus loin en détail, les deux bulles situées respectivement aux extrémités de deux registres peuvent être prises en compte pour le contour d'accès, simultanément, pour être acheminées vers deux stations d'accès opposées. Il résulte de cette organisation en registres complémentaires, que le temps d'accès à une bulle, est divisé par deux ; il est donc possible de doubler le débit de lecture et d'écriture, en disposant une station d'accès de chaque côté du contour d'accès, comme on le verra plus loin en détail. De plus, on peut aussi accéder à deux adresses consécutives proches, puisque le champ tournant est arrêté pendant une opération de lecture ou d'écriture.

L'invention a pour objet une mémoire à bulles magnétiques comprenant au moins deux séries de registres principaux à décalage disposés de part et d'autre d'une frontière transversale, lesdits registres principaux étant constitués par des motifs définis par implantation ionique dans une couche de grenat magnétique, lesdits motifs définissant de part et d'autre de ladite frontière des répartitions complémentaires de zones implantées et de zones non implantées, lesdits registres principaux étant constitués par un profil continu ondulé réalisé par implantation ionique et le déplacement des bulles le long de ces registres se faisant à l'aide d'un champ tournant, la mémoire comprenant en outre un contour d'accès situé à cheval sur la ligne frontière, ledit contour d'accès étant tel qu'à chaque extrémité d'un registre principal correspond une position du contour d'accès, ce contour d'accès permettant l'échange de bulles entre registres principaux situés d'un même côté de la ligne frontière ou situés de part et d'autre de la frontière, caractérisée en ce que le contour d'accès est constitué par un système d'ouvertures réalisées dans au moins une couche conductrice superposée à la couche de grenat magnétique et isolée de ce grenat, le déplacement des bulles dans le contour d'accès se faisant à l'aide d'impulsions de courant à double polarité appliquées à ladite couche conductrice le champ tournant étant interrompu pendant le fonctionnement du contour d'accès.

Selon un mode de réalisation, les ouvertures de la couche conductrice du contour d'accès, sont associées à des motifs réalisés par implantation ionique dans la couche de grenat magnétique.

Selon un autre mode de réalisation, la couche conductrice comprend deux feuilles conductrices superposées à la couche de grenat magnétique, isolées entre elles et isolées de la couche de grenat, chaque feuille pouvant recevoir des impulsions à double polarité.

Selon un autre mode de réalisation, la mémoire comprend en outre deux séries de registres secondaires à décalage en regard des registres principaux, ces registres secondaires étant constitués par des motifs définis par implantation ionique dans la couche de grenat magnétique, et des moyens de transfert de bulles, entre les registres des séries de registres principaux et les registres secondaires qui leur correspondent et, entre les registres secondaires qui se correspondent dans les différentes séries de registres secondaires.

Selon un autre mode de réalisation, les motifs de séries de registres principaux et les motifs de registres secondaires qui leur correspondent définissent respectivement des répartitions complémentaires de zones implantées et de zones non implantées.

Selon un autre mode de réalisation, les motifs de différentes séries de registres secondaires définissent respectivement des répartitions complémentaires de zones implantées et de zones non implantées.

D'autres caractéristiques et avantages de l'invention ressortiront mieux de la description qui va suivre donnée en référence aux dessins annexés dans lesquels :

la figure 1 représente schématiquement un premier mode de réalisation d'une mémoire conforme à l'invention,

la figure 2 représente schématiquement un second mode de réalisation d'une mémoire conforme à l'invention,

la figure 3 représente schématiquement l'organisation générale d'une mémoire conforme à l'invention.

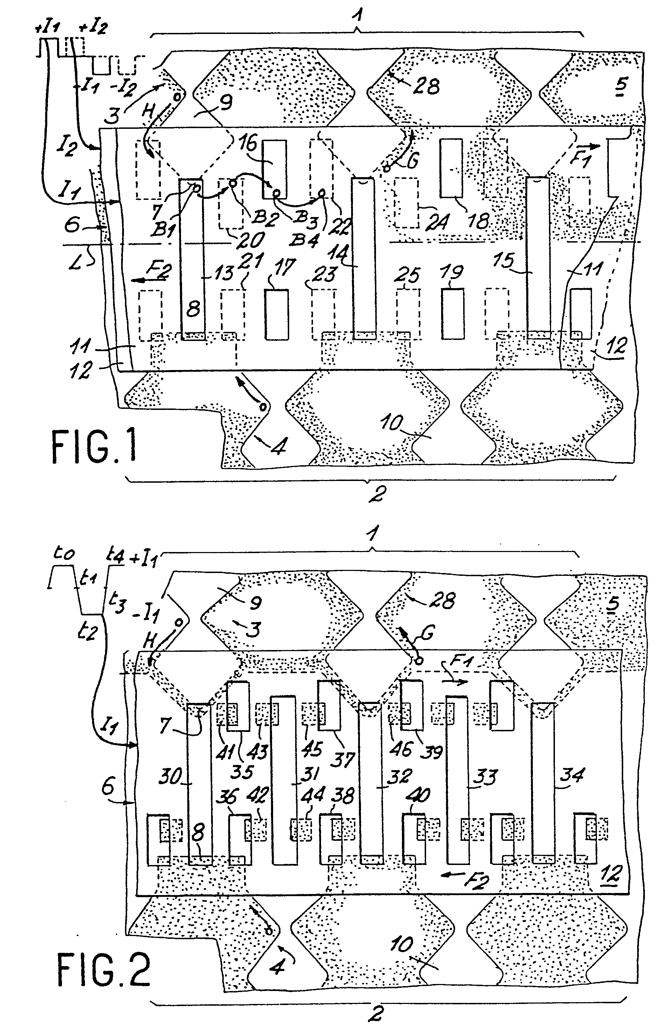

La figure 1 représente schématiquement un premier mode de réalisation d'une mémoire à bulles conforme à l'invention. Cette mémoire à bulles comprend deux séries 1, 2, de registres 3, 4, à décalage, orientés longitudinalement et des moyens (connus et non représentés) pour produire un décalage des bulles B dans ces registres, dans le sens de la flèche H par exemple, par application d'un champ magnétique tournant. Les moyens connus qui permettent d'appliquer un champ magnétique tournant aux registres à décalage peuvent être constitués par des bobines disposées en quadrature et tournant à fréquence constante. Ce champ tournant peut être supprimé et rétabli sans perturber l'information, de façon à ne pas être obligé d'alimenter la mémoire, alors qu'elle ne fonctionne pas. Bien entendu, cette mémoire comprend aussi, de façon connue, des moyens qui ne sont pas représentés et qui permettent de créer les bulles dans les registres. Ces bulles sont créées selon les besoins, par exemple au moyen d'un conducteur produisant un champ opposé au champ de polarisation. Les registres longitudinaux sont constitués par des motifs qui présentent approximativement la forme de losanges sur la figure, mais qui pourraient avoir tout autre forme et qui sont définis par implantation ionique dans une couche 5 d'un grenat magnétique. De tels motifs sont décrits dans le document EP-A-38754 déposée le 18 avril 1980 au nom du même demandeur. La couche de grenat magnétique qui a pour formule GdYTmGaIG par exemple est implantée, par masquage des parties qui ne doivent pas être implantées, et par bombardement d'ions He$^+$. Cette implantation ionique étant délimitée comme on le verra par la suite, les bulles formées circulent dans une couche (non représentée sur la figure) d'un grenat magnétique qui peut être qualifiée de « couche d'enregistrement » et qui est située en dessous de la couche 5 dans laquelle sont définis les motifs constituant les registres à décalage. Cette couche d'enregistrement peut être constituée par exemple dans un matériau de formule EuYTmGaIG. Enfin, de manière connue, les deux couches précédentes sont supportées par un substrat amagnétique de formule $Gd_3Ga_5O_{12}$ par exemple. Les séries 1, 2 de registres principaux 3, 4 sont disposées respectivement de part et d'autre d'une frontière L et dans le cas particulier représenté, de part et d'autre du contour d'accès transversal 6. c e registre présente pour chaque extrémité d'accès 7, 8, des registres principaux 3, 4, un seul point d'accès. Il en résulte que l'accès à chacun des registres principaux de séries 1, 2, se fait bulle par bulle. Selon l'invention, les registres principaux constitués par des motifs définis par implantation ionique, de part et d'autre du contour d'accès 6, forment des répartitions complémentaires de zones implantées et de zones non implantées. C'est ainsi que dans le mode de réalisation représenté sur la figure, les zones non implantées pour la série de registres 1, sont représentées en 9, tandis que les zones implantées pour la série 2, de registres principaux 4, sont représentées en 10. La délimitation de la zone implantée, pour la série des registres 1 est représentée par la ligne L. Le contour d'accès 6 comprend par exemple des moyens d'accès par courant électrique qui sont constitués, dans ce premier mode de réalisation de la mémoire, par deux feuilles conductrices 11, 12, superposées à la couche 5 de grenat magnétique, à proximité des extrémités d'accès 7, 8 des registres principaux 3, 4. Ces feuilles sont isolées entre elles et isolées du grenat magnétique par des couches de matériau isolant (non représentées sur la figure) ; elles sont percées d'ouvertures disposées de manière qu'au moins l'une des feuilles, telles que la feuille 11 par exemple, présente des ouvertures 13, 14, 15, situées en regard des extrémités d'accès 7, 8, des registres principaux. Les autres ouvertures de ces feuilles sont disposées de manière à acheminer chaque bulle parvenue à l'extrémité des registres principaux 3, 4 par exemple, soit vers une station d'accès, soit vers d'autres registres principaux de la série de registres représentée sur la figure. Les ouvertures telles que 13, 14, 15, 16, 17, 18, 19 sont réalisées dans la première feuille conductrice 11, tandis que les ouvertures telles que 20, 21, 22, 23, 24, 25, ... etc, sont réalisées dans la feuille conductrice 12 par exemple. Lorsqu'une bulle est parvenue à une extrémité 7 par exemple d'un registre principal 3, elle peut être acheminée, grâce au contour d'accès, soit vers une station d'accès, soit vers un autre registre principal de l'une des séries 1 ou 2 des registres principaux. A cet effet, des sources électriques de courant (non représentées) permettent d'appliquer des impulsions de courant $I_1$, $I_2$, à chacune des feuilles conductrices 11, 12, de manière à assurer le cheminement des bulles dans le contour d'accès. Ces impulsions présentent une double polarité et des amplitudes respectives $+ I_1$, $+ I_2$, $- I_1$, $- I_2$. L'accès à une bulle située à l'extrémité d'un registre principal de la première série 1 de registres et à une bulle située à l'extrémité d'un registre principal de la deuxième série 2 de registres ainsi que la circulation de ces bulles, s'opèrent de la manière suivante : une bulle est parvenue à l'extrémité 7 du registre à décalage 3 de la première série de registres 1. A cet instant, le champ tournant qui était appliqué aux registres à décalage, est arrêté par des moyens appropriés, puis une impulsion $+ I_1$ est appliquée à la feuille conductrice 11. Cette impulsion provoque, de manière connue, de part et d'autre de l'ouverture 13, l'apparition de pôles positifs et négatifs, de sorte que la bulle est alors attirée par le pôle positif de la position $B_1$ par exemple. en regard de l'ouverture 13. Une impulsion $+ I_2$ est alors appliquée à la feuille conductrice 12, de sorte que des pôles positifs et négatifs apparaissent de part et d'autre de l'ouverture 20 réalisée dans cette feuille conductrice. La bulle est alors attirée dans la position $B_2$ en regard de l'ouverture 20. On applique ensuite à la feuille conductrice 11, une impulsion négative $- I_1$ qui provoque l'apparition de pôles positifs et négatifs de part et d'autre de l'ouverture 16. La bulle est alors attirée dans la position $B_3$ en regard de l'ouverture 16. On applique alors une impulsion $- I_2$ à la feuille conductrice 12, de sorte qu'il apparaît des pôles positifs et négatifs, tels que représentés sur la figure, de part et d'autre de l'ouverture 22 de cette feuille. La bulle est alors attirée dans la position $B_4$. Ainsi, la bulle à laquelle on a eu accès, à l'extrémité 7 du registre 3, peut être acheminée dans le sens de la flèche $F_1$, vers une station d'accès (non représentée), par applications successives des impulsions $I_1$ et $I_2$ décrites précédemment.

On peut également, au moment où la bulle est située en regard de l'ouverture 14, arrêter l'application d'impulsions aux feuilles conductrices 11, 12, et appliquer de nouveau le champ tournant, de manière à faire circuler cette bulle, par décalages successifs, dans le registre 28 par exemple, jusqu'à une position prédéterminée, selon le parcours représenté par la flèche G. De la même manière, une bulle parvenue à l'extrémité 8 du registre à décalage 4 par exemple, peut être acheminée grâce au contour d'accès, dans le sens de la flèche $F_2$, vers une autre station d'accès ; elle peut également être acheminée vers un registre de la série des registres 1, puisque le contour d'accès peut être un contour bouclé. Il en est de même pour une bulle recueillie dans la série de registres 1, qui peut être acheminée, puisque le contour d'accès peut être bouclé, vers l'un des registres de la série de registres complémentaires 2. Le cheminement d'une bulle recueillie dans l'un des registres complémentaires de la série de registres 2, ne sera pas décrit ici en détail puisqu'il s'opère de la même manière que le cheminement décrit précédemment pour une bulle recueillie dans la série de registres 1. Le cheminement d'une bulle recueillie dans l'un des registres de la série de registres 2, s'opère en sens inverse du cheminement décrit précédemment ; en effet, les registres des séries 1 et 2 sont complémentaires et, pour une même position du champ tournant, les puits de potentiel pour ces deux séries, sont face à face et les bulles qui y seraient piégées, peuvent être prises en compte par le contour d'accès, sans faire appel à une rotation supplémentaire du champ tournant. C'est ainsi que dans l'exemple de réalisation représenté sur la figure, les deux bulles situées respectivement aux extrémités 7 et 8 des registres 3 et 4, peuvent être prises en compte par le contour d'accès, simultanément, pour être acheminées vers deux stations d'accès opposées. Il résulte de cette organisation en registres complémentaires, que le temps d'accès à une bulle, est divisé par deux ; il est donc possible de doubler le débit de lecture et d'écriture, en disposant une station d'accès de chaque côté du contour d'accès, comme on le verra plus loin en détail. De plus, on peut aussi accéder à deux adresses consécutives proches, puisque le champ tournant est arrêté pendant une opération de lecture ou d'écriture.

La figure 2 représente schématiquement un autre mode de réalisation d'une mémoire conforme à l'invention. Les mêmes éléments portent les mêmes références sur cette figure et sur la figure précédente. On distingue sur cette figure, la couche de grenat magnétique 5 et les deux séries 1, 2 de registres principaux complémentaires 3, 4, constitués par des motifs définis par implantation ionique dans la couche de grenat magnétique 5. Comme dans le cas précédent, les zones non implantées sont représentées en 9 à l'intérieur des losanges pour la série de registres principaux 1, tandis que les zones implantées sont représentées en 10, pour la série de registres principaux complémentaires 2. Dans la série des registres principaux 1, la limite de la zone implantée est représentée en traits interrompus, par la ligne brisée L. Selon ce second mode de réalisation de la mémoire conforme à l'invention, les moyens d'accès 6 aux registres principaux des séries 1, 2 comprennent par exemple des moyens d'accès par courant électrique constitués par une feuille conductrice 12, superposée à la couche de grenat magnétique 5, à proximité des extrémités d'accès 7, 8 des registres principaux ; cette feuille est isolée de la couche de grenat magnétique par une couche d'un matériau isolant (non représentée sur la figure) et elle est percée d'ouvertures 30, 31... 40 ; certaines de ces ouvertures 30, 31, 32... sont situées en regard des extrémités d'accès 7, 8, des registres principaux des séries de registres 1, 2. Les autres ouvertures 35, 36... 40, coopèrent avec des motifs d'accès 41, 42, ... 46, définis par implantation ionique dans la couche de grenat magnétique 5, de manière à acheminer chaque bulle recueillie à l'extrémité d'un registre de chaque série, soit vers une station d'accès (non représentée), dans le sens des flèches $F_1$ ou $F_2$, soit vers un autre registre tel que le registre 15 dans le sens de la flèche G. Le parcours des bulles dans le contour d'accès 6 s'effectue de la manière suivante : la feuille conductrice 12 est reliée à une source électrique de courant (non représentée), appliquant à cette feuille des impulsions de courant $I_1$ à double polarité. Si une bulle se trouve présente, par exemple à l'extrémité 7 du registre principal 3 de la série des registres 1, le champ tournant est arrêté par des moyens appropriés et la bulle est attirée en regard de l'ouverture 30, du côté des pôles positifs qui apparaissent dans cette ouverture, par suite de l'application d'ume impulsion de courant $+ I_1$, dans cette feuille conductrice, à l'instant $t_0$. A l'instant $t_1$, le courant dans la feuille conductrice est nul et la bulle se trouve en regard du motif 41. A l'instant $t_2$, une impulsion négative $- I_1$ est appliquée à la feuille conductrice 6 ; des pôles positifs et négatifs apparaissent de part et d'autre de l'ouverture 35. La bulle se trouve ainsi, en regard de cette ouverture, du côté du pôle positif. A l'instant $t_3$, la bulle se trouve en regard du motif 43, tandis qu'à l'instant $t_4$, l'application d'une impulsion positive $+ I_1$ à la feuille conductrice 6, provoque l'apparition de pôles positifs et négatifs, de part et d'autre de l'ouverture 31 ; la bulle est attirée en regard de la partie supérieure de l'ouverture 31. Le processus se reproduit alors de manière identique, de manière que la bulle soit dirigée vers un station d'accès (non représentée) dans le sens de la flèche $F_1$ ou vers un autre registre de la série de registres à décalage, tel que par exemple, le registre 28, dans le sens de la flèche G. En effet, lorsque la bulle qui a été prise en compte à l'extrémité 7 du registre 3, parvient en regard de l'ouverture 32, il est possible d'appliquer à nouveau le champ magnétique tournant de manière que la bulle circule en sens inverse dans le registre 28 par exemple. Les bulles prises en compte à la partie inférieure du contour d'accès circulent en sens inverse, dans le sens de la flèche $F_2$, pour aboutir à une autre station d'accès (non représentée) ou à un autre registre de la série de registres principaux 2.

Comme dans le mode de réalisation précédent, on peut également faire circuler une bulle prise en compte à l'extrémité de l'un des registres de la série de registres 1, dans le contour d'accès, pour l'amener dans l'un des registres de la série de registres 2, ou réciproquement. Les registres principaux des séries 1 et 2, qui sont constitués par des motifs définis par implantation ionique et qui présentent de part et d'autre d'une frontière ou du contour d'accès, des répartitions complémentaires de zones implantées et de zones non implantées, permettent, pour une même position du champ tournant, de prendre en compte les bulles qui sont parvenues aux extrémités de deux registres situés en regard et appartenant aux deux séries différentes de registres principaux. Cette particularité est due à la complémentarité des zones implantées et des zones non implantées, qui permet d'obtenir des puits de potentiel, face à face, dans les deux séries de registres. Comme dans le mode de réalisation précédent, le temps d'accès peut être diminué de moitié et il est possible de doubler le débit d'écriture ou de lecture, en disposant une station d'accès de chaque côté du contour d'accès.

La figure 3 représente schématiquement l'organisation générale d'une mémoire conforme à l'invention. Selon cette organisation, la mémoire comprend en outre des séries 50, 51, de registres secondaires à décalage, orientés longitudinalement et situés en regard des registres principaux des séries 1, 2. Les décalages des bulles dans les registres secondaires sont commandés par les moyens d'application du champ tournant, décrits plus haut. Ces registres secondaires sont constitués comme précédemment, par des motifs définis par implantation ionique, dans une couche de grenat magnétique. Des moyens 53, 54 et 55, 56, sont prévus pour assurer le transfert des bulles, respectivement entre les registres principaux 1, 2 et les registres secondaires 50, 51, ou entre les registres secondaires 50, 57, ou encore entre les registres secondaires 51, 58. Sur la figure, les zones implantées par exemple, sont représentées par des grisés, de sorte que les motifs des séries de registres principaux et les motifs des séries de registres secondaires qui leur correspondent, définissent respectivement des répartitions complémentaires de zones implantées et de zones non implantées. De la même manière, les différentes séries de registres secondaires, telles que les séries 50, 57 par exemple, définissent respectivement des répartitions complémentaires de zones implantées et de zones non implantées.

Sur la figure, les moyens d'accès transversaux sont représentés en 6. Ils permettent notamment d'acheminer les bulles vers les stations d'accès $S_1$ ou $S_2$. Les moyens de transfert 53, 54, 55, 56 comprennent par exemple au moins des moyens de transfert par courant électrique et ne sont pas représentés ici en détail. Ils sont constitués de la même manière que les moyens d'accès décrits en exemple à propos du premier mode de réalisation de l'invention. Ces moyens de transfert par courant comprennent deux feuilles conductrices superposées à la couche de grenat magnétique, à proximité des extrémités des registres ; ces feuilles sont isolées entre elles et isolées du grenat magnétique et sont percées d'ouvertures disposées de manière qu'au moins une des feuilles présente des ouvertures tangentes aux extrémités des registres ; les autres ouvertures de ces feuilles sont disposées de manière à transférer les bulles entre des séries de registres secondaires qui se correspondent dans les différentes séries de registres secondaires, ou entre les registres principaux et les registres secondaires qui leur correspondent.

Selon un autre mode de réalisation (non représenté), les moyens de transfert sont constitués de la même manière que les moyens d'accès décrits en exemple à propos du second mode de réalisation de l'invention. Ils comprennent par exemple des moyens de transfert par courant électrique, constitués par une feuille conductrice superposée à la feuille de grenat magnétique, à proximité des extrémités des registres. Cette feuille est isolée de la couche de grenat magnétique et elle est percée d'ouvertures disposées de manière que certaines d'entre elles soient tangentes respectivement avec les extrémités des registres. Les autres ouvertures coopèrent avec des motifs de transfert, définis par implantation ionique dans la couche de grenat magnétique, de manière à transférer les bulles entre des registres secondaires qui se correspondent dans les différentes séries de registres secondaires ou, entre les registres principaux et les registres secondaires qui leur correspondent. Ces feuilles conductrices sont alimentées, comme décrit précédemment, par des sources électriques d'alimentation fournissant des impulsions de courant de double polarité.

Les moyens de transfert permettent de commander les transferts d'informations entre des registres correspondants disposés longitudinalement dans la mémoire. Dans cette organisation de mémoire, conforme à l'invention, la répartition des registres de part et d'autre du contour d'accès, permet de diminuer le temps d'accès. En gardant la même capacité pour une surface donnée de mémoire, on peut accéder deux fois plus vite aux bulles contenues dans les registres longitudinaux. De plus, du fait de la présence des moyens de transfert, les informations peuvent être très rapidement transférées d'un registre à un autre, à l'intérieur de la mémoire. On peut ainsi échanger rapidement, entre registres, des pages d'informations.

Le contour d'accès et les moyens de transfert qui viennent d'être décrits correspondent à ceux qui ont été décrits dans la demande européenne EP-A-38754 au nom du même demandeur.

## Revendications

1. Mémoire à bulles magnétiques comprenant au moins deux séries de registres principaux (3, 4) à décalage, disposés de part et d'autre d'une frontière transversale (L), lesdits registres principaux étant constitués par des motifs définis par implantation ionique dans une couche (5) de grenat magnétique, lesdits motifs définissant de part et d'autre de ladite frontière (L) des répartitions complémentaires de zones implantées (10) et de zones non implantées (9), lesdits registres principaux (3, 4) étant constitués par un profil continu ondulé réalisé par implantation ionique et le déplacement des bulles le long de ces registres étant effectué à l'aide d'un champ tournant, la mémoire comprenant en outre un contour d'accès situé à cheval sur la ligne frontière, ledit contour d'accès étant tel qu'à chaque extrémité d'un registre principal correspond une position du contour d'accès, ce contour d'accès permettant l'échange de bulles entre les registres principaux situés d'un même côté de la ligne frontière (L) ou situés de part et d'autre de la frontière (L), caractérisée en ce que le contour d'accès est constitué par un système d'ouvertures (13, ... 19, 20, ... 25) réalisées dans au moins une couche conductrice (6) superposée à la couche (5) de grenat magnétique et isolée de ce grenat, le déplacement des bulles dans le contour d'accès se faisant à l'aide d'impulsions de courant à double polarité appliquées à ladite couche conductrice (6), le champ tournant étant interrompu pendant le fonctionnement du contour d'accès.

2. Mémoire à bulles selon la revendication 1, caractérisée en ce que les ouvertures de la couche conductrice (6) du contour d'accès sont associées à des motifs (41, 42...) réalisés par implantation ionique dans la couche (5) de grenat magnétique.

3. Mémoire à bulles selon la revendication 1, caractérisée en ce que la couche conductrice (6) comprend deux feuilles conductrices (11, 12) superposées à la couche (5) de grenat magnétique isolées entre elles et isolées de la couche (5) de grenat, chaque feuille pouvant recevoir des impulsions à double polarité.

4. Mémoire à bulles selon l'une quelconque des revendications 1 et 2, caractérisée en ce qu'elle comprend en outre des séries (50, 51, 57, 58) de registres secondaires à décalage orientés longitudinalement en regard des registres principaux (1, 2), ces registres secondaires étant constitués par la couche de grenat magnétique, et des moyens de transfert (53, 54, 55, 56) de bulles, entre les registres des séries de registres principaux (1, 2) et les registres secondaires qui leur correspondent et, entre les registres secondaires (50, 51) qui se correspondent dans les différentes séries de registres secondaires (51, 58, 50, 57).

5. Mémoire à bulles selon la revendication 4, caractérisée en ce que les motifs des séries (1, 2) de registres principaux et les motifs des registres secondaires (50, 51) qui leur correspondent définissent respectivement des répartitions complémentaires de zones implantées et de zones non implantées.

6. Mémoire à bulles selon la revendication 5, caractérisée en ce que les motifs des différentes séries de registres secondaires (50, 51, 57, 58) définissent respectivement des répartitions complémentaires de zones implantées et de zones non implantées.

7. Mémoires à bulles selon l'une quelconque des revendications 4 à 6, caractérisée en ce que les moyens de transfert (6, 52, 54, 55, 56) comprenant des registres à décalage constitués de points mémoires des registres principaux ou secondaires.

## Claims

1. Magnetic bubble memory comprising at least two series of principal shift registers (3, 4), located on respective sides of a boundary (L), said principal registers being constituted by patterns defined by ion-implantation in a magnetic garnet layer (5), said patterns defining on respective sides of said boundary (L) the complementary division of implanted zones (10) and non-implanted zones (9), said principal registers (3, 4) comprising a continuous undulating profile provided by ion implantation, and displacement of the bubbles along the registers is effected with a rotating field, the memory additionally comprising an access circuit situated astride the boundary, said access circuit being such that each end of a principal register corresponds to a position on the access circuit, said access circuit enabling the exchange of bubbles between principal registers situated on the same side of the boundary (L) or situated on either side of the boundary (L), characterized in that the access circuit comprises a system of openings (13, ..., 19, 20, ... 25) formed in at least one conductive layer (6) superimposed on the magnetic garnet layer (5) and insulated from said garnet, displacement of bubbles into the access circuit being provided by the aid of bipolar current impulses applied to said conductive layer (6), the rotating field being interrupted during operation of the access circuit.

2. Bubble memory according to Claim 1, characterized in that the openings in the conductive layer (6) of the access circuit are associated with patterns (41, 42...) formed by ion implantation in the magnetic garnet layer (5).

3. Bubble memory according to Claim 1, characterized in that the conductive layer (6) comprises two conductive foils (11, 12) superimposed on the magnetic garnet layer (5), and insulated from one another and from the magnetic garnet layer (5), each foil being adapted to receive bipolar current impulses.

4. Bubble memory according to either one of Claims 1 and 2, characterized in that it additionally comprises a series (50, 51, 57, 58) of secondary shift registers longitudinally oriented with respect to the principal registers (1, 2), said secondary registers comprising patterns defined by ion-implantation in the magnetic garnet layer, and bubble-transfer means (53, 54, 55, 56) between the registers of the principal register series (1, 2) and the corresponding secondary registers, and between corresponding secondary registers (50, 51) of the different secondary register series (51, 58, 50, 57).

5. Bubble memory according to Claim 4, characterized in that the patterns of the principal register series (1, 2) and the patterns of the corresponding secondary register (50, 51) respectively define complementary divisions between implanted zones and non-implanted zones.

6. Bubble memory according to Claim 5, characterized in that the patterns of the different series of secondary registers (50, 51, 57, 58) respectively define complementary divisions between implanted zones and non-implanted zones.

7. Bubble memory according to any one of Claims 4 to 6, characterized in that the transfer means (6, 52, 54, 55, 56) comprise shift registers comprising memory points of the principal or secondary registers.

## Ansprüche

1. Magnetblasenspeicher, mit mindestens zwei Reihen von versetzten Hauptregistern (3, 4), die auf beiden Seiten einer quer verlaufenden Grenze (L) angeordnet und von Mustern gebildet sind, die durch Ionenimplantation in einer Schicht (5) aus magnetischem Granat festgelegt sind, wobei die Muster auf beiden Seiten der Grenze (L) komplementäre Aufteilungen der implantierten Bereiche (10) und der nichtimplantierten Bereiche (9) festlegen und die Hauptregister (3, 4) von einem durch Ionenimplantation erzeugten, fortlaufenden, gewellten Profil gebildet sind und die Verschiebung der Blasen längs dieser Register mittels eines Drehfeldes durchgeführt wird, und wobei der Speicher ferner einen sich quer über der Grenzlinie befindenden Zugriffsbereich derart aufweist, daß jedem Ende eines Hauptregisters eine Position des Zugriffsbereiches entspricht, wobei der Zugriffsbereich den Austausch von Blasen zwischen Hauptregistern erlaubt, die sich auf der gleichen Seite der Grenzlinie (L) oder auf beiden Seiten der Grenze (L) befinden, dadurch gekennzeichnet, daß der Zugriffsbereich von einem System von Öffnungen (13... 19, 20... 25) gebildet ist, die in wenigstens einer leitenden Schicht (6) ausgebildet sind, die der Schicht (5) aus magnetischem Granat überlagert und von diesem Granat isoliert ist, daß die Verschiebung der Blasen in dem Zugriffsbereich mit Hilfe von an die leitende Schicht (6) gelegten Stromimpulsen doppelter Polarität erfolgt und daß während des Betriebes des Zugriffsbereiches das Drehfeld unterbrochen ist.

2. Magnetblasenspeicher nach Anspruch 1, dadurch gekennzeichnet, daß die Öffnungen der leitenden Schicht (6) des Zugriffsbereiches mit Mustern (41, 42...) verbunden sind, die durch Ionenimplantation in der Schicht (5) aus magnetischem Granat hergestellt sind.

3. Magnetblasenspeicher nach Anspruch 1, dadurch gekennzeichnet, daß die leitende Schicht (6) zwei leitende Schichten (11, 12) umfaßt, die der Schicht (5) aus magnetischem Granat überlagert und voneinander und von der Schicht (5) aus Granat isoliert sind, und daß jede Schicht Impulse doppelter Polarität empfangen kann.

4. Magnetblasenspeicher nach einem der Ansprüche 1 oder 2, dadurch gekennzeichnet, daß dieser ferner umfaßt Reihen (50, 51, 57, 58) von versetzten, zweiten Registern, die in bezug auf die Hauptregister (1, 2) in Längsrichtung orientiert sind, wobei diese zweiten Register von durch lonenimplantation in der Schicht aus magnetischem Granat festgelegten Mustern gebildet sind, sowie Blasenüberführungsmittel (53, 54, 55, 56) zwischen den Registern der Reihen von Hauptregistern (1, 2) und den zweiten Registern, die ihnen entsprechen, und zwischen den zweiten Registern (50, 51) die sich in den verschiedenen Reihen von zweiten Registern (51, 58, 50, 57) entsprechen.

5. Magnetblasenspeicher nach Anspruch 4, dadurch gekennzeichnet, daß die Muster der Reihen (1, 2) von Hauptregistern und die Muster der zweiten Register (50, 51), die ihnen entsprechen, komplementäre Aufteilungen der implantierten Bereiche und der nichtimplantierten Bereiche festlegen.

6. Magnetblasenspeicher nach Anspruch 5, dadurch gekennzeichnet, daß die Muster der verschiedenen Reihen von zweiten Registern (50, 51, 57, 58) komplementäre Aufteilungen der implantierten Bereiche und der nichtimplantierten Bereiche festlegen.

7. Magnetblasenspeicher nach irgendeinem der Ansprüche 4 bis 6, dadurch gekennzeichnet, daß die Übertragungsmittel (6, 52, 54, 55, 56) versetzte Register umfassen, die von Speicherpunkten der Hauptregister oder zweiten Register gebildet sind.

FIG.1

FIG.2

FIG.3